# FASCICULE DE BREVET EUROPEEN

(11) **EP 3 510 412 B1**
(45) Date de publication et mention de la délivrance du brevet: **08.03.2023**
(21) Numéro de dépôt: 17780789.8
(22) Date de dépôt: 05.09.2017
(51) Int. Cl.: G01R 15/08, H03G 1/00, G01R 19/00, H03F 3/72

(54) **DISPOSITIF D'AMPLIFICATION ELECTRONIQUE, APPAREIL DE MESURE ET PROCEDE DE MESURE ASSOCIES**
ELEKTRONISCHE VERSTÄRKUNGSVORRICHTUNG, MESSVORRICHTUNG UND ZUGEHÖRIGES MESSVERFAHREN
ELECTRONIC AMPLIFICATION DEVICE, MEASUREMENT APPARATUS AND ASSOCIATED MEASUREMENT METHOD

(30) Priorité: 06.09.2016 FR 1658273
(43) Date de publication de la demande: 17.07.2019
(73) Titulaire: Commissariat à l'énergie atomique et aux énergies alternatives, 75015 Paris (FR)
(72) Inventeur: HAMRITA, Hassen, 91160 Champlan (FR); BOURBOTTE, Jean-Michel, 28700 Aunay Sous Auneau (FR); KONDRASOVS, Vladimir, 91120 Palaiseau (FR); MAKIL, Hamid, 91380 Chilly-Mazarin (FR)
(74) Mandataire: Brevalex
(86) Numéro de dépôt international: PCT/FR2017/052339
(87) Numéro de publication internationale: WO 2018/046830

(56) Documents cités:
- EP-A1- 0 155 197
- US-A1- 2003 095 058
- US-A1- 2008 143 320
- US-A1- 2013 009 655

## Description

### DOMAINE TECHNIQUE

La présente invention concerne un dispositif d'amplification. L'invention concerne également un appareil de mesure et un procédé de mesure.

L'invention s'applique à la mesure d'une caractéristique d'un signal électrique. En particulier, l'invention s'applique à la mesure de courants continus de très faible intensité, par exemple à la mesure de courants continus de très faible intensité issus de détecteurs de rayonnement ionisant.

### ÉTAT DE LA TECHNIQUE ANTÉRIEURE

Suite à l'accident de Fukushima, la mesure du flux neutrons et flux gamma sur les réacteurs dits « de troisième génération » a pris une grande importance. Or, dans un bâtiment réacteur, le flux neutronique est susceptible de varier entre quelques
10 n.cm⁻².s⁻¹ (neutrons par centimètre carré et par seconde) et quelques 10¹⁴ n.cm⁻².s⁻¹, et le flux gamma de quelques 10² à 10¹¹ gamma. cm⁻².s⁻¹.

Parmi les différents types de détecteurs de rayonnement, les collectrons, encore connus sous l'acronyme SPND (de l'anglais « *Self Powered Neutron Detector* », signifiant détecteur de neutrons autoalimenté), et les chambres d'ionisation constituent, actuellement, les seuls détecteurs aptes à réaliser des mesures sur une telle plage.

Les collectrons présentent l'avantage de fonctionner sans source d'alimentation. En effet, dans un tel détecteur, l'interaction des neutrons ou des photons gamma avec les matériaux du détecteur génère des électrons. Le mouvement de ces électrons dans le détecteur génère un courant électrique continu dont l'intensité est proportionnelle au flux gamma ou au flux neutronique détecté. Un tel courant présente généralement une intensité comprise entre 1 pA (picoampère) et quelques 10 mA (milliampère), suivant le flux de rayonnement détecté. Le courant électrique généré par un collectron présente donc une grande dynamique, à savoir une dynamique de l'ordre de 10¹⁰.

Par « dynamique », il est entendu, au sens de la présente invention, le rapport entre les valeurs extrêmes atteintes par une grandeur physique, par exemple atteintes par le courant électrique généré par un collectron.

Par « grande dynamique », il est généralement entendu une dynamique supérieure ou égale à 10⁴.

Le courant généré par un collectron étant susceptible de présenter des valeurs relativement faibles, un tel courant nécessite d'être amplifié avant d'être mesuré.

Il est connu d'utiliser des amplificateurs linéaires pour amplifier un courant électrique. Toutefois, les amplificateurs linéaires de courant disponibles dans le commerce sont sujets à des phénomènes de saturation qui rendent de tels amplificateurs inadéquats pour l'amplification de signaux électriques présentant une grande dynamique.

Le document US 2003/0095058 A1 divulgue un dispositif d'amplification selon le préambule de la revendication 1. Le document EP 0155197 A1 décrit un amplificateur logarithmique propre à amplifier des courants électriques présentant une grande dynamique.

Toutefois, un tel amplificateur ne donne pas entière satisfaction.

En effet, un tel amplificateur logarithmique est peu précis, du fait du recours à une transformation logarithmique. En outre, le fonctionnement d'un tel amplificateur logarithmique repose sur l'utilisation de diodes. Or, les diodes présentent une faible stabilité en température, ce qui nuit à la stabilité en température d'un tel amplificateur logarithmique.

Un but de l'invention est donc de proposer un dispositif d'amplification qui présente moins de risques de saturation pour des signaux électriques présentant une grande dynamique et dont le signe est prédéterminé, et qui est plus stable en température et plus précis que les amplificateurs de l'état de la technique.

### EXPOSÉ DE L'INVENTION

A cet effet, l'invention a pour objet un dispositif d'amplification, qui comporte une borne intermédiaire pour recevoir un signal intermédiaire, une borne de sortie et un étage d'amplification connecté entre la borne intermédiaire et la borne de sortie.

L'étage d'amplification comprend :
- un commutateur comportant une sortie connectée à la borne de sortie, une première entrée et une deuxième entrée, le commutateur étant propre à commuter entre une première position, dans laquelle la sortie est connectée à la première entrée, et une deuxième position, dans laquelle la sortie est connectée à la deuxième entrée ;
- une première branche connectée entre la borne intermédiaire et la première entrée du commutateur, la première branche étant configurée pour appliquer un premier gain au signal intermédiaire afin de générer un premier signal amplifié destiné à être délivré à la première entrée du commutateur ;
- une deuxième branche connectée entre la borne intermédiaire et la deuxième entrée du commutateur, la deuxième branche étant configurée pour appliquer un deuxième gain au signal intermédiaire afin de générer un deuxième signal amplifié destiné à être délivré à la deuxième entrée du commutateur ;
- un contrôleur configuré pour commander la commutation du commutateur :
   - dans la première position pour appliquer le premier signal amplifié à la borne de sortie, si la valeur d'une grandeur prédéterminée du premier signal amplifié appartient à une plage prédéterminée ;
   - dans la deuxième position pour appliquer le deuxième signal amplifié à la borne de sortie, si la valeur de la grandeur prédéterminée du premier signal amplifié est en dehors de la plage prédéterminée.

Le premier gain et le deuxième gain sont des réels non nuls de signes opposés.

En effet, dans un tel dispositif d'amplification, l'étage d'amplification est apte à amplifier :
- une première gamme de courant, correspondant à une plage d'intensités pour laquelle le premier gain est appliqué, et pour laquelle les composants de la première branche n'entrent pas en saturation ; et
- une deuxième gamme de courant, correspondant à une plage d'intensités pour laquelle le deuxième gain est appliqué, et pour laquelle les composants de la deuxième branche n'entrent pas en saturation.

La commutation entre la première gamme et la deuxième gamme se fait automatiquement par la commande du commutateur. Par une telle commutation entre la première branche et la deuxième branche de l'étage d'amplification, une grande dynamique de courant du signal d'entrée est couverte, et les problèmes de saturation sont évités.

En outre, le signal de sortie présente un signe qui dépend uniquement du gain appliqué et du signe prédéterminé du signal intermédiaire. Ainsi, la position de commutateur est codée par le signe du signal de sortie. Ceci simplifie le décodage automatique du signal de sortie : en effet, le signe du signal de sortie indique automatiquement quel gain a été appliqué.

Par signe prédéterminé d'un signal, il doit être entendu que le signe du signal est prédéterminé à un instant donné. Ainsi, dans le cas de l'utilisation principalement visée par l'invention où ledit signal est un signal continu, comme cela est le cas pour les signaux issus des collectrons, le signe du signal correspond au signe attendu pour ledit signal (généralement positif). Dans le cas où le signal est un signal présentant un signe pouvant varié, le signe est prédéterminé à un instant donné, ceci soit par une mesure amont, soit par une variation prévisible du signal.

Suivant d'autres aspects avantageux de l'invention, le dispositif d'amplification comporte une ou plusieurs des caractéristiques suivantes, prise(s) isolément ou suivant toutes les combinaisons techniquement possibles :
- il comporte, en outre, une borne d'entrée et un préamplificateur connecté entre la borne d'entrée et la borne intermédiaire, le préamplificateur est configuré pour appliquer un gain préliminaire à un signal d'entrée reçu en provenance de la borne d'entrée pour générer le signal intermédiaire destiné à être délivré à la borne intermédiaire, le gain préliminaire étant un réel non nul ;
- la deuxième branche de l'étage d'amplification présente un gain unitaire.

En outre, l'invention a pour objet un appareil de mesure qui comprend un dispositif d'amplification selon l'invention, ainsi qu'un calculateur connecté à la borne de sortie du dispositif d'amplification, le calculateur étant configuré pour calculer une valeur d'une caractéristique prédéterminée d'un signal intermédiaire de signe prédéterminé reçu par la borne intermédiaire de l'appareil de mesure égale :
- si le signal intermédiaire est positif, à :
   - la valeur de la grandeur prédéterminée du signal de sortie divisée par le premier gain, si la valeur de la grandeur prédéterminée du signal de sortie est du même signe que le premier gain ;
   - la valeur de la grandeur prédéterminée du signal de sortie divisée par le deuxième gain, si la valeur de la grandeur prédéterminée du signal de sortie n'est pas du même signe que le premier gain ;
- si le signal intermédiaire est négatif, à :
   - la valeur de la grandeur prédéterminée du signal de sortie divisée par le premier gain, si la valeur de la grandeur prédéterminée du signal de sortie n'est pas du même signe que le premier gain ;
   - la valeur de la grandeur prédéterminée du signal de sortie divisée par le deuxième gain, si la valeur de la grandeur prédéterminée du signal de sortie est du même signe que le premier gain.

En outre, l'invention a pour objet un procédé de mesure correspondant.

### BRÈVE DESCRIPTION DES DESSINS

L'invention sera mieux comprise à l'aide de la description qui va suivre, donnée uniquement à titre d'exemple non limitatif et faite en se référant aux dessins annexés sur lesquels :
- la figure 1 est une représentation schématique d'un appareil de mesure selon l'invention ;
- la figure 2 est une représentation schématique d'un mode particulier de réalisation de l'appareil de mesure de la figure 1; et
- la figure 3 est un graphique représentant l'évolution d'un signal de sortie d'un dispositif d'amplification de l'appareil de mesure de la figure 2, en fonction d'un signal d'entrée de l'appareil de mesure de courant.

### EXPOSÉ DÉTAILLÉ DE MODES DE RÉALISATION PARTICULIERS

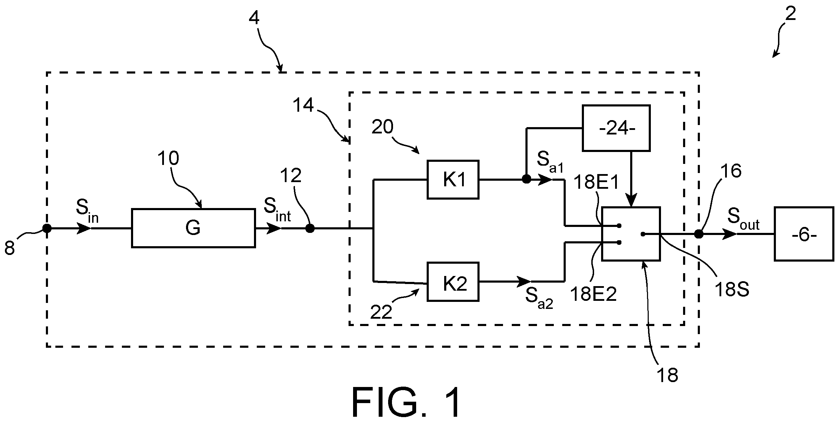

Un appareil de mesure 2 selon l'invention est illustré par la figure 1. L'appareil de mesure 2 est configuré pour mesurer la valeur d'une caractéristique prédéterminée d'un signal électrique. Par exemple, l'appareil de mesure 2 est un appareil de mesure de courant, en particulier un appareil de mesure de courant pour des courants électriques continus dont l'intensité présente une grande dynamique et est également susceptible d'atteindre des valeurs relativement faibles, tels que des courants électriques continus de très faible intensité issus de détecteurs de rayonnement et de particules, par exemple issus de chambres d'ionisation ou de collectrons.

Par « courant de très faible intensité », il est entendu, au sens de la présente invention, un courant électrique présentant une intensité inférieure ou égale à quelques dizaines de picoampères, par exemple inférieure ou égale à 10 pA (picoampère).

L'appareil de mesure 2 est propre à recevoir un signal d'entrée sᵢₙ électrique, et à déterminer la valeur de la caractéristique prédéterminée du signal d'entrée sᵢₙ, par exemple l'intensité du signal d'entrée sᵢₙ.

L'appareil de mesure 2 comprend un dispositif d'amplification 4 et un calculateur 6.

Le dispositif d'amplification 4 est configuré pour fournir un signal de sortie sₒᵤₜ dont une grandeur prédéterminée est représentative de la caractéristique prédéterminée du signal d'entrée sᵢₙ. Par exemple, le dispositif d'amplification 4 est configuré pour fournir un signal de sortie sₒᵤₜ dont la tension est représentative de l'intensité du signal d'entrée sᵢₙ.

Le calculateur 6 est relié au dispositif d'amplification 4 pour recevoir le signal de sortie sₒᵤₜ. Le calculateur 6 est configuré pour calculer la valeur de la caractéristique prédéterminée du signal d'entrée sᵢₙ à partir de la valeur de la première grandeur prédéterminée du signal de sortie sₒᵤₜ.

Le dispositif d'amplification 4 comporte une borne d'entrée 8, un préamplificateur 10, une borne intermédiaire 12, un étage d'amplification 14 et une borne de sortie 16.

Le préamplificateur 10 est connecté entre la borne d'entrée 8 et la borne intermédiaire 12. L'étage d'amplification 14 est connecté entre la borne intermédiaire 12 et la borne de sortie 16.

Le préamplificateur 10 est propre à recevoir le signal d'entrée sᵢₙ appliqué à la borne d'entrée 8. Le préamplificateur 10 est, en outre, configuré pour appliquer un gain préliminaire G au signal d'entrée sᵢₙ, pour délivrer un signal intermédiaire sᵢₙₜ à la borne intermédiaire 12. Le signal intermédiaire sᵢₙₜ est proportionnel au signal d'entrée sᵢₙ.

L'étage d'amplification 14 est configuré pour mettre en forme le signal intermédiaire sᵢₙₜ afin de fournir, au niveau de la borne de sortie 16, le signal de sortie sₒᵤₜ.

L'étage d'amplification 14 comprend un commutateur 18, une première branche 20, une deuxième branche 22, et un contrôleur 24.

Le commutateur 18 comporte une première entrée 18E1, une deuxième entrée 18E2 et une sortie 18S.

La sortie 18S du commutateur 18 est connectée à la borne de sortie 16.

La première branche 20 de l'étage d'amplification 14 est connectée entre la borne intermédiaire 12 et la première entrée 18E1 du commutateur 18. En outre, la deuxième branche 22 de l'étage d'amplification 14 est connectée entre la borne intermédiaire 12 et la deuxième entrée 18E2 du commutateur 18.

La première branche 20 de l'étage d'amplification 14 est propre à recevoir le signal intermédiaire sᵢₙₜ en provenance de la borne intermédiaire 14. En outre, la première branche 20 est configurée pour appliquer un premier gain K1 au signal intermédiaire sᵢₙₜ reçu, pour délivrer un premier signal amplifié sₐ₁ à la première entrée 18E1 du commutateur 18.

La deuxième branche 22 de l'étage d'amplification 14 est propre à recevoir le signal intermédiaire sᵢₙₜ en provenance de la borne intermédiaire 14. En outre, la deuxième branche 22 est configurée pour appliquer un deuxième gain K2 au signal intermédiaire sᵢₙₜ reçu, pour délivrer un deuxième signal amplifié sₐ₂ à la deuxième entrée 18E2 du commutateur 18.

Par « gain », il est entendu, au sens de la présente invention, le résultat de la division de la valeur d'une grandeur physique donnée d'un signal électronique disponible en sortie d'un système électronique par la valeur de la grandeur physique d'un signal correspondant appliqué en entrée du système électronique. Le gain est un réel positif ou négatif.

Le premier gain K1 et le deuxième gain K2 sont des réels non nuls de signes opposés. Le premier gain K1 et le gain préliminaire G sont également des réels non nuls de signes opposés.

Le contrôleur 24 est connecté à l'une parmi la première entrée 18E1 et la deuxième entrée 18E2 du commutateur 18.

Le contrôleur 24 est configuré pour déterminer si la valeur de la grandeur prédéterminée du premier signal amplifié sₐ₁ appliqué à la première entrée 18E1 du commutateur 18, respectivement du deuxième signal amplifié sₐ₂ appliqué à la deuxième entrée 18E2 du commutateur 18, appartient à une plage autorisée correspondante.

Par exemple, dans le cas où la grandeur prédéterminée est la tension, le contrôleur 24 est propre à déterminer si la tension du premier signal amplifié sₐ₁, respectivement du deuxième signal amplifié sₐ₂, appartient à un intervalle de tension dont au moins une borne est une tension de saturation de la première branche 20, respectivement de la deuxième branche 22, la tension de saturation étant exclue de l'intervalle.

En particulier, le contrôleur 24 est propre à comparer la valeur de la grandeur prédéterminée du premier signal amplifié sₐ₁, respectivement du deuxième signal amplifié sₐ₂, à une valeur prédéterminée.

Par exemple, dans le cas où la grandeur prédéterminée est la tension, le contrôleur 24 est propre à comparer la tension du premier signal amplifié sₐ₁, respectivement du deuxième signal amplifié sₐ₂, à une tension de saturation basse -Vₛₐₜ négative de la première branche 20, respectivement à une tension de saturation haute +Vₛₐₜ positive de la deuxième branche 22. Dans ce cas, la plage autorisée correspond aux valeurs de tension qui sont strictement supérieures à la tension de saturation basse -Vₛₐₜ de la première branche 20, respectivement strictement inférieures à la tension de saturation haute +Vₛₐₜ de la deuxième branche 22.

Un tel exemple sera notamment mis en oeuvre dans le cas où la première branche 20 présente une tension de saturation basse -Vₛₐₜ inférieure, en valeur absolue, à la tension de saturation basse -Vₛₐₜ de la deuxième branche 22.

Le contrôleur 24 est, par exemple, un comparateur connu.

En outre, dans le cas où le contrôleur 24 est connecté à la première entrée 18E1 du commutateur 18, le contrôleur 24 est configuré pour commander la commutation du commutateur 18 :
- dans la première position pour appliquer le premier signal amplifié sₐ₁ à la borne de sortie 16, si la valeur de la grandeur prédéterminée du premier signal sₐ₁ appartient à la plage autorisée correspondante ;
- dans la deuxième position pour appliquer le deuxième signal amplifié sₐ₂ à la borne de sortie 16, si la valeur de la grandeur prédéterminée du premier signal sₐ₁ se trouve en dehors de la plage autorisée.

Dans le cas où le contrôleur 24 est connecté à la deuxième entrée 18E2 du commutateur 18, le contrôleur 24 est configuré pour commander la commutation du commutateur 18 :
- dans la deuxième position pour appliquer le deuxième signal amplifié sₐ₂ à la borne de sortie 16, si la valeur de la grandeur prédéterminée du deuxième signal sₐ₂ appartient à la plage autorisée correspondante ;
- dans la première position pour appliquer le premier signal amplifié sₐ₁ à la borne de sortie 16, si la valeur de la grandeur prédéterminée du deuxième signal sₐ₂ se trouve en dehors de la plage autorisée.

Le calculateur 6 est configuré pour mesurer la valeur de la grandeur prédéterminée du signal de sortie sₒᵤₜ. En outre, le calculateur 6 est configuré pour stocker la valeur de chacun parmi le gain préliminaire G, le premier gain K1 et le deuxième gain K2.

Le calculateur 6 est également configuré pour calculer la valeur de la caractéristique prédéterminée du signal d'entrée sᵢₙ à partir de la valeur de la grandeur prédéterminée du signal de sortie sₒᵤₜ et du signe de la grandeur prédéterminée du signal de sortie sₒᵤₜ. En particulier, le calculateur calcule une valeur de la caractéristique prédéterminée du signal d'entrée sᵢₙ qui est égale à la valeur de la grandeur prédéterminée du signal de sortie sₒᵤₜ divisée par le gain préliminaire G et par :
- le premier gain K1 si la valeur de la grandeur prédéterminée du signal de sortie sₒᵤₜ est négative ;
- le deuxième gain K2 si la valeur de la grandeur prédéterminée du signal de sortie sₒᵤₜ est positive.

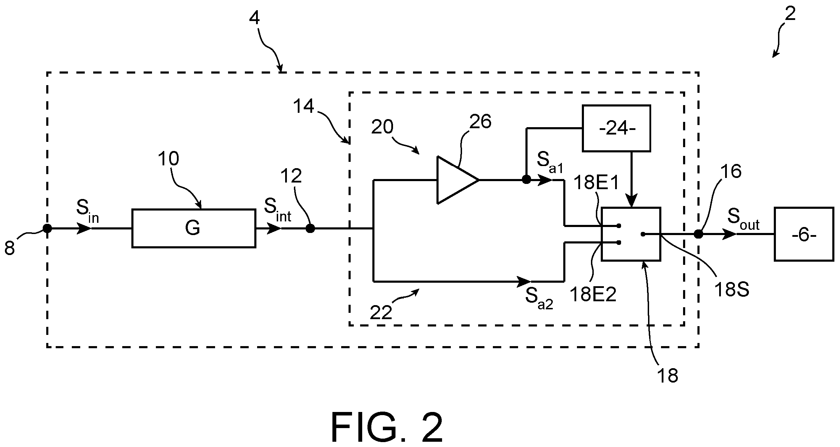

Dans le mode de réalisation illustré par la figure 2, l'appareil de mesure 2 est configuré pour mesurer l'intensité du signal d'entrée sᵢₙ. Un tel signal d'entrée sᵢₙ est notamment un signal délivré par un détecteur de flux neutronique ou de flux gamma, tel qu'un collectron ou une chambre d'ionisation.

Comme représenté sur la figure 2, la deuxième branche 22 est un simple fil électrique. Dans ce cas, le deuxième gain K2 est unitaire. En outre, le gain préliminaire G est positif, et le premier gain K1 est négatif.

Par exemple, le préamplificateur 10 est un amplificateur à transimpédance classiquement connu. Dans ce cas, le préamplificateur 10 présente avantageusement un gain préliminaire G dont la valeur absolue est supérieure ou égale à 10⁶ V/A (volt par ampère), de préférence supérieure ou égale à 10⁷ V/A, par exemple de l'ordre de 10⁸ V/A.

Par exemple, la première branche 20 comprend un amplificateur 26 connecté en montage inverseur entre la borne intermédiaire 12 et la première entrée 18E1 du commutateur 18. Dans ce cas, la valeur absolue du premier gain K1 est égale au gain de l'amplificateur 26. Avantageusement, l'amplificateur 26 présente un gain supérieur ou égal à 10, de préférence supérieur ou égal à 50, par exemple de l'ordre de 100.

Avantageusement, l'amplificateur 26 est un amplificateur opérationnel d'instrumentation de précision, classiquement connu.

En outre, dans le mode de réalisation de la figure 2, le commutateur 18 est un relais à double commutation, de type SPDT (de l'anglais « *single pole, double throw* », également appelé inverseur).

Le contrôleur 24 est relié à la première entrée 18E1 du commutateur 18.

En outre, le contrôleur 24 est un circuit constituant un montage d'hystérésis connu. Dans ce cas, le contrôleur 24 agit comme un comparateur configuré pour comparer la tension du premier signal amplifié sₐ₁ à une tension de consigne égale à la tension de saturation basse -Vₛₐₜ de l'amplificateur 26, par exemple une tension de consigne égale à -10 V. Dans ce cas, le contrôleur 24 est configuré pour polariser une bobine du commutateur 18, si la tension du premier signal amplifié sₐ₁ atteint -10 V, afin de faire commuter le commutateur 18 dans la deuxième position.

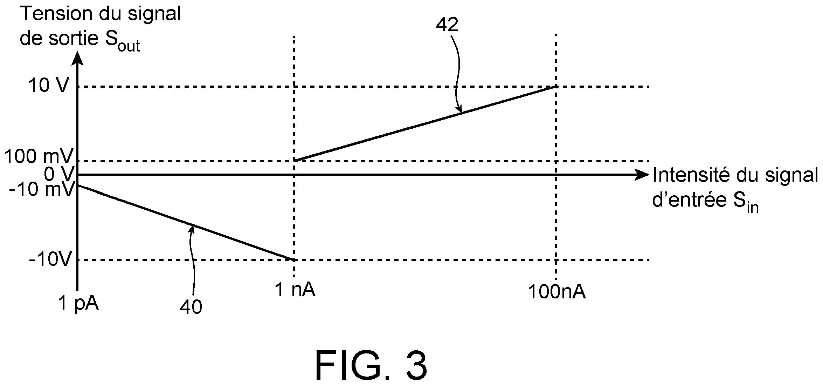

Le fonctionnement de l'appareil de mesure 2 va maintenant être décrit, en se fondant sur le mode de réalisation de la figure 2, et en faisant référence à la figure 3.

Dans cet exemple, le signal d'entrée sᵢₙ est positif, c'est-à-dire que l'intensité du signal d'entrée sᵢₙ est positive.

Le préamplificateur 10 présente un gain préliminaire G égal à 10⁸ V/A.

L'amplificateur 26 présente un gain égal à 100. Dans ce cas, la première branche 22 présente un premier gain K1 égal à -100.

La tension de saturation basse -Vₛₐₜ de l'amplificateur 26 est égale -10 V.

L'appareil de mesure 2 est relié à une détecteur pour recevoir le signal d'entrée sᵢₙ formé par un courant continu présentant une intensité comprise entre 1 pA et 100nA.

Si l'intensité du signal d'entrée sᵢₙ appartient à l'intervalle [1 pA; 1 nA[, alors le signal intermédiaire sᵢₙₜ présente une tension appartenant à l'intervalle [100 µV; 100 mV[.

Le signal intermédiaire sᵢₙₜ passe à travers la première branche 20. Le premier signal amplifié sₐ₁ disponible à la première entrée 18E1 du commutateur 18 présente une tension appartenant à l'intervalle [-10 V ; -10 mV].

La tension du premier signal amplifié sₐ₁ étant strictement supérieur à la tension de saturation basse -Vₛₐₜ de l'amplificateur 26, le contrôleur 24 commande le commutateur 18 pour que le commutateur 18 soit placé dans la première position, c'est-à-dire la position dans laquelle la première entrée 18E1 du commutateur 18 est électriquement reliée à la sortie 18S du commutateur 18. Dans ce cas, le signal de sortie sₒᵤₜ est égal au premier signal amplifié sₐ₁.

L'évolution de la tension du signal de sortie sₒᵤₜ pour un signal d'entrée sᵢₙ présentant une intensité appartenant à l'intervalle [1 pA ; 1 nA[ est illustrée par le segment 40 du graphique de la figure 3.

La tension du signal de sortie sₒᵤₜ étant négative, le calculateur 6 calcule une intensité du signal d'entrée sᵢₙ égale à la tension du signal de sortie sₒᵤₜ divisée par le produit du gain préliminaire G et du premier gain K1, c'est-à-dire divisée par -10¹⁰ V/A.

Dès que l'intensité du signal d'entrée sᵢₙ atteint 1 pA, c'est-à-dire dès que la tension du premier signal amplifié sₐ₁ atteint -10 V, le contrôleur 24 commande la commutation du commutateur 18 dans la deuxième position, c'est-à-dire la position dans laquelle la deuxième entrée 18E2 du commutateur 18 est électriquement reliée à la sortie 18S du commutateur 18. Dans ce cas, le signal de sortie sₒᵤₜ est égal au deuxième signal amplifié sₐ₂. La deuxième branche 22 étant, dans l'exemple, un simple fil, le deuxième signal amplifié sₐ₂ est le signal intermédiaire sᵢₙₜ.

Le contrôleur 24 commande le commutateur 18 pour que le commutateur 18 soit placé dans la deuxième position pour toutes les valeurs d'intensité du signal d'entrée sᵢₙ susceptibles de faire saturer l'amplificateur 26, c'est-à-dire pour toutes valeurs d'intensité du signal d'entrée sᵢₙ appartenant à l'intervalle [1 nA ; 100 nA].

L'évolution de la tension du signal de sortie sₒᵤₜ pour un signal d'entrée sᵢₙ présentant une intensité appartenant à l'intervalle [1 nA; 100 nA] est illustrée par le segment 42 du graphique de la figure 3.

Comme cela apparaît sur la figure 3, dans ce cas, la tension du signal de sortie sₒᵤₜ varie entre 100 mV et 10 V.

La tension du signal de sortie sₒᵤₜ étant positive, le calculateur 6 calcule une intensité du signal d'entrée sᵢₙ égale à la tension du signal de sortie sₒᵤₜ divisée par le produit du gain préliminaire G et du deuxième gain K2, c'est-à-dire divisée par 10⁸ V/A.

Selon une variante non représentée, le préamplificateur 10 est un simple fil électrique. Dans ce cas, le gain préliminaire G vaut 1. En outre, la borne d'entrée 8 et la borne intermédiaire 12 sont confondues.

## Revendications

1. Dispositif d'amplification (2) comportant une borne intermédiaire (12) pour recevoir un signal intermédiaire (sᵢₙₜ), une borne de sortie (16) et un étage d'amplification (14), l'étage d'amplification (14) étant connecté entre la borne intermédiaire (12) et la borne de sortie (16),
le dispositif d'amplification (2) étant **caractérisé en ce que** l'étage d'amplification (14) comprend :
- un commutateur (18) comportant une sortie (18S) connectée à la borne de sortie (16), une première entrée (18E1) et une deuxième entrée (18E2), le commutateur (18) étant propre à commuter entre une première position, dans laquelle la sortie (18S) est connectée à la première entrée (18E1), et une deuxième position, dans laquelle la sortie (18S) est connectée à la deuxième entrée (18E2) ;
- une première branche (20) connectée entre la borne intermédiaire (12) et la première entrée (18E1) du commutateur (18), la première branche (20) étant configurée pour appliquer un premier gain (K1) au signal intermédiaire (sᵢₙₜ) afin de générer un premier signal amplifié (sₐ₁) destiné à être délivré à la première entrée (18E1) du commutateur (18) ;
- une deuxième branche (22) connectée entre la borne intermédiaire (12) et la deuxième entrée (18E2) du commutateur (18), la deuxième branche (22) étant configurée pour appliquer un deuxième gain (K2) au signal intermédiaire (sᵢₙₜ) afin de générer un deuxième signal amplifié (sₐ₂) destiné à être délivré à la deuxième entrée (18E2) du commutateur (18) ;
- un contrôleur (24) configuré pour commander la commutation du commutateur (18) :
- dans la première position pour appliquer le premier signal amplifié (sₐ₁) à la borne de sortie (16), si la valeur d'une grandeur prédéterminée du premier signal amplifié (sₐ₁) appartient à une plage prédéterminée ;
- dans la deuxième position pour appliquer le deuxième signal amplifié (sₐ₂) à la borne de sortie (16), si la valeur de la grandeur prédéterminée du premier signal amplifié (sₐ₁) est en dehors de la plage prédéterminée ;
**caractérisé en ce que** le premier gain (K1) et le deuxième gain (K2) sont des réels non nuls de signes opposés.

2. Dispositif d'amplification (2) selon la revendication 1, le dispositif d'amplification (2) comportant, en outre, une borne d'entrée (8) et un préamplificateur (10) connecté entre la borne d'entrée (8) et la borne intermédiaire (12),
le préamplificateur (10) étant configuré pour appliquer un gain préliminaire (G) à un signal d'entrée (sᵢₙ) reçu en provenance de la borne d'entrée (8) pour générer le signal intermédiaire (sᵢₙₜ) destiné à être délivré à la borne intermédiaire (12),
le gain préliminaire (G) étant un réel non nul.

3. Dispositif d'amplification (2) selon revendication 2, dans lequel la deuxième branche (22) de l'étage d'amplification (14) présente un gain unitaire.

4. Appareil (2) de mesure, comprenant un dispositif d'amplification (2) selon la revendication 1, et un calculateur (6) connecté à la borne de sortie (16) du dispositif d'amplification (2),
le calculateur (6) étant configuré pour calculer une valeur d'une caractéristique prédéterminée d'un signal intermédiaire (sᵢₙₜ) de signe prédéterminé reçu par la borne intermédiaire (12) de l'appareil de mesure (2) égale :
- si le signal intermédiaire (sᵢₙₜ) est positif, à :
- la valeur de la grandeur prédéterminée d'un signal de sortie (sₒᵤₜ) disponible au niveau de la borne de sortie (16) divisée par le premier gain (K1), si la valeur de la grandeur prédéterminée du signal de sortie (sₒᵤₜ) est du même signe que le premier gain (K1) ;
- la valeur de la grandeur prédéterminée du signal de sortie (sₒᵤₜ) divisée par le deuxième gain (K2), si la valeur de la grandeur prédéterminée du signal de sortie (sₒᵤₜ) n'est pas du même signe que le premier gain (K1) ;
- si le signal intermédiaire (sᵢₙₜ) est négatif, à :
- la valeur de la grandeur prédéterminée du signal de sortie (sₒᵤₜ) divisée par le premier gain (K1), si la valeur de la grandeur prédéterminée du signal de sortie (sₒᵤₜ) n'est pas du même signe que le premier gain (K1) ;
- la valeur de la grandeur prédéterminée du signal de sortie (sₒᵤₜ) divisée par le deuxième gain (K2), si la valeur de la grandeur prédéterminée du signal de sortie (sₒᵤₜ) est du même signe que le premier gain (K1).

5. Procédé de mesure de la valeur d'une caractéristique prédéterminée d'un signal intermédiaire (sᵢₙₜ) présentant un signe prédéterminé et appliqué sur la borne intermédiaire (12) de l'appareil de mesure (2) selon la revendication 4, le procédé comportant les étapes de :
- mesure de la valeur de la grandeur prédéterminée du signal de sortie (Saut) ;
- calcul de la valeur de la caractéristique prédéterminée du signal intermédiaire (sᵢₙₜ), la valeur de la caractéristique prédéterminée du signal intermédiaire (sᵢₙₜ) étant égale :
- si le signal intermédiaire (sᵢₙₜ) est positif, à :
- la valeur de la grandeur prédéterminée du signal de sortie (sₒᵤₜ) divisée par le premier gain (K1), si la valeur de la grandeur prédéterminée du signal de sortie (sₒᵤₜ) est du même signe que le premier gain (K1) ;
- la valeur de la grandeur prédéterminée du signal de sortie (sₒᵤₜ) divisée par le deuxième gain (K2), si la valeur de la grandeur prédéterminée du signal de sortie (sₒᵤₜ) n'est pas du même signe que le premier gain (K1) ;
- si le signal intermédiaire (sᵢₙ) est négatif, à :
- la valeur de la grandeur prédéterminée du signal de sortie (sₒᵤₜ) divisée par le premier gain (K1), si la valeur de la grandeur prédéterminée du signal de sortie (sₒᵤₜ) n'est pas du même signe que le premier gain (K1) ;
- la valeur de la grandeur prédéterminée du signal de sortie (sₒᵤₜ) divisée par le deuxième gain (K2), si la valeur de la grandeur prédéterminée du signal de sortie (sₒᵤₜ) est du même signe que le premier gain (K1)

6. Appareil (2) de mesure, comprenant un dispositif d'amplification (2) selon la revendication 2 ou 3, et un calculateur (6) connecté à la borne de sortie (16) du dispositif d'amplification (2),
le calculateur (6) étant configuré pour calculer une valeur d'une caractéristique prédéterminée d'un signal d'entrée (sᵢₙ) de signe prédéterminé, appliqué en entrée de l'appareil de mesure (2), égale à :
- si le signal d'entrée (sᵢₙ) est positif, à :
- la valeur de la grandeur prédéterminée du signal de sortie (sₒᵤₜ) divisée par le gain préliminaire (G) et par le premier gain (K1), si la valeur de la grandeur prédéterminée d'un signal de sortie (sₒᵤₜ) disponible au niveau de la borne de sortie (16) est du même signe que le produit du gain préliminaire (G) et du premier gain (K1) ;
- la valeur de la grandeur prédéterminée du signal de sortie (sₒᵤₜ) divisée par le gain préliminaire (G) et par le deuxième gain (K2), si la valeur de la grandeur prédéterminée du signal de sortie (sₒᵤₜ) n'est pas du même signe que le produit du gain préliminaire (G) et du premier gain (K1) ;
- si le signal d'entrée (sᵢₙ) est négatif, à :
- la valeur de la grandeur prédéterminée du signal de sortie (sₒᵤₜ) divisée par le gain préliminaire (G) et par le premier gain (K1), si la valeur de la grandeur prédéterminée du signal de sortie (sₒᵤₜ) n'est pas du même signe que le produit du gain préliminaire (G) et du premier gain (K1) ;
- la valeur de la grandeur prédéterminée du signal de sortie (sₒᵤₜ) divisée par le gain préliminaire (G) et par le deuxième gain (K2), si la valeur de la grandeur prédéterminée du signal de sortie (sₒᵤₜ) est du même signe que le produit du gain préliminaire (G) et du premier gain (K1).

7. Procédé de mesure de la valeur d'une caractéristique prédéterminée d'un signal d'entrée (sᵢₙ) de signe prédéterminé appliqué en entrée de l'appareil de mesure (2) selon la revendication 6, le procédé comportant les étapes de :
- mesure de la valeur de la grandeur prédéterminée du signal de sortie (Saut) ;
- calcul de la valeur de la caractéristique prédéterminée du signal d'entrée (sᵢₙ), la valeur de la caractéristique prédéterminée du signal d'entrée (sᵢₙ) étant égale à :
- si le signal d'entrée (sᵢₙ) est positif, à :
- la valeur de la grandeur prédéterminée du signal de sortie (sₒᵤₜ) divisée par le gain préliminaire (G) et par le premier gain (K1), si la valeur de la grandeur prédéterminée du signal de sortie (sₒᵤₜ) est du même signe que le produit du gain préliminaire (G) et du premier gain (K1) ;
- la valeur de la grandeur prédéterminée du signal de sortie (sₒᵤₜ) divisée par le gain préliminaire (G) et par le deuxième gain (K2), si la valeur de la grandeur prédéterminée du signal de sortie (sₒᵤₜ) n'est pas du même signe que le produit du gain préliminaire (G) et du premier gain (K1) ;
- si le signal d'entrée (sᵢₙ) est négatif, à :
- la valeur de la grandeur prédéterminée du signal de sortie (sₒᵤₜ) divisée par le gain préliminaire (G) et par le premier gain (K1), si la valeur de la grandeur prédéterminée du signal de sortie (sₒᵤₜ) n'est pas du même signe que le produit du gain préliminaire (G) et du premier gain (K1) ;
- la valeur de la grandeur prédéterminée du signal de sortie (sₒᵤₜ) divisée par le gain préliminaire (G) et par le deuxième gain (K2), si la valeur de la grandeur prédéterminée du signal de sortie (sₒᵤₜ) est du même signe que le produit du gain préliminaire (G) et du premier gain (K1).

## Patentansprüche

1. Verstärkervorrichtung (2), eine Zwischenklemme (12) beinhaltend zum Empfangen eines Zwischensignals (sᵢₙₜ), eine Ausgangsklemme (16) und eine Verstärkerstufe (14), wobei die Verstärkerstufe (14) zwischen der Zwischenklemme (12) und der Ausgangsklemme (16) angeschlossen ist,
wobei die Verstärkervorrichtung (2) **dadurch gekennzeichnet ist, dass** die Verstärkerstufe (14) umfasst:
- einen Wechselschalter (18), einen Ausgang (18S) beinhaltend, der an die Ausgangsklemme (16) angeschlossen ist, einen ersten Eingang (18E1) und einen zweiten Eingang (18E2), wobei der Wechselschalter (18) geeignet ist, zwischen einer ersten Position zu wechseln, in der der Ausgang (18S) am ersten Eingang (18E1) angeschlossen ist, und einer zweiten Position, in der der Ausgang (18S) am zweiten Eingang (18E2) angeschlossen ist;
- einen ersten Zweig (20), der zwischen der Zwischenklemme (12) und dem ersten Eingang (18E1) des Wechselschalters (18) angeschlossen ist, wobei der erste Zweig (20) konfiguriert ist, um eine erste Verstärkung (K1) auf das Zwischensignal (sᵢₙₜ) anzuwenden, damit ein erstes verstärktes Signal (sₐ₁) erzeugt wird, das dazu bestimmt ist, an den ersten Eingang (18E1) des Wechselschalters (18) ausgegeben zu werden;
- einen zweiten Zweig (22), der zwischen der Zwischenklemme (12) und dem zweiten Eingang (18E2) des Wechselschalters (18) angeschlossen ist, wobei der zweite Zweig (22) konfiguriert ist, um eine zweite Verstärkung (K2) auf das Zwischensignal (sᵢₙₜ) anzuwenden, damit ein zweites verstärktes Signal (sₐ₂) erzeugt wird, das dazu bestimmt ist, an den zweiten Eingang (18E2) des Wechselschalters (18) ausgegeben zu werden;
- einen Steuerschalter (24), konfiguriert, um das Wechseln des Wechselschalters (18) zu steuern:
- in die erste Position, um das erste verstärkte Signal (sₐ₁) an die Ausgangsklemme (16) anzulegen, wenn der Wert einer vorbestimmten Größe des ersten verstärkten Signals (sₐ₁) zu einem vorbestimmten Bereich gehört;
- in die zweite Position, um das zweite verstärkte Signal (sₐ₂) an die Ausgangsklemme (16) anzulegen, wenn der Wert der vorbestimmten Größe des ersten verstärkten Signals (sₐ₁) außerhalb des vorbestimmten Bereichs liegt;
**dadurch gekennzeichnet, dass** die erste Verstärkung (K1) und die zweite Verstärkung (K2) reelle Zahlen ungleich null mit entgegengesetzten Vorzeichen sind.

2. Verstärkervorrichtung (2) nach Anspruch 1, wobei die Verstärkervorrichtung (2) ferner eine Eingangsklemme (8) und einen Vorverstärker (10) beinhaltet, der zwischen der Eingangsklemme (8) und der Zwischenklemme (12) angeschlossen ist,
wobei der Vorverstärker (10) konfiguriert ist, um eine vorläufige Verstärkung (G) auf ein Eingangssignal (sᵢₙ) anzuwenden, das von der Eingangsklemme (8) empfangen wird, um das Zwischensignal (sᵢₙₜ) zu erzeugen, das dazu bestimmt ist, an die Zwischenklemme (12) ausgegeben zu werden,
wobei die vorläufige Verstärkung (G) eine reelle Zahl ungleich null ist.

3. Verstärkervorrichtung (2) nach Anspruch 2, wobei der zweite Zweig (22) der Verstärkerstufe (14) eine Einheitsverstärkung aufweist.

4. Messgerät (2), eine Verstärkervorrichtung (2) nach Anspruch 1 umfassend, und einen Rechner (6), der an die Ausgangsklemme (16) der Verstärkervorrichtung (2) angeschlossen ist,
wobei der Rechner (6) konfiguriert ist, um einen Wert einer vorbestimmten Eigenschaft eines Zwischensignals (sᵢₙₜ) mit vorbestimmtem Vorzeichen zu berechnen, das von der Zwischenklemme (12) des Messgerätes (2) empfangen wird, der gleich ist, wie:
- wenn das Zwischensignal (sᵢₙₜ) positiv ist:
- der Wert der vorbestimmten Größe eines Ausgangssignals (sₒᵤₜ), das an der Ausgangsklemme (16) verfügbar ist, dividiert durch die erste Verstärkung (K1), wenn der Wert der vorbestimmten Größe des Ausgangssignals (sₒᵤₜ) das gleiche Vorzeichen wie die erste Verstärkung (K1) hat;
- der Wert der vorbestimmten Größe des Ausgangssignals (sₒᵤₜ) dividiert durch die zweite Verstärkung (K2), wenn der Wert der vorbestimmten Größe des Ausgangssignals (sₒᵤₜ) nicht das gleiche Vorzeichen wie die erste Verstärkung (K1) hat;
- wenn das Zwischensignal (sᵢₙₜ) negativ ist:
- der Wert der vorbestimmten Größe des Ausgangssignals (sₒᵤₜ) dividiert durch die erste Verstärkung (K1), wenn der Wert der vorbestimmten Größe des Ausgangssignals (sₒᵤₜ) nicht das gleiche Vorzeichen wie die erste Verstärkung (K1) hat;
- der Wert der vorbestimmten Größe des Ausgangssignals (sₒᵤₜ) dividiert durch die zweite Verstärkung (K2), wenn der Wert der vorbestimmten Größe des Ausgangssignals (sₒᵤₜ) das gleiche Vorzeichen wie die erste Verstärkung (K1) hat.

5. Verfahren zur Messung des Wertes einer vorbestimmten Eigenschaft eines Zwischensignals (sᵢₙₜ), der ein vorbestimmtes Vorzeichen aufweist und an die Zwischenklemme (12) des Messgerätes (2) nach Anspruch 4 angelegt ist, wobei das Verfahren die Schritte beinhaltet:
- Messung des Wertes der vorbestimmten Größe des Ausgangssignals (sₒᵤₜ);
- Berechnung des Wertes der vorbestimmten Eigenschaft des Zwischensignals (sᵢₙₜ), wobei der Wert der vorbestimmten Eigenschaft des Zwischensignals (sᵢₙₜ) gleich ist, wie:
- wenn das Zwischensignal (sᵢₙₜ) positiv ist:
- der Wert der vorbestimmten Größe des Ausgangssignals (sₒᵤₜ) dividiert durch die erste Verstärkung (K1), wenn der Wert der vorbestimmten Größe des Ausgangssignals (sₒᵤₜ) das gleiche Vorzeichen wie die erste Verstärkung (K1) hat;
- der Wert der vorbestimmten Größe des Ausgangssignals (sₒᵤₜ) dividiert durch die zweite Verstärkung (K2), wenn der Wert der vorbestimmten Größe des Ausgangssignals (sₒᵤₜ) nicht das gleiche Vorzeichen wie die erste Verstärkung (K1) hat;
- wenn das Zwischensignal (sᵢₙ) negativ ist:
- der Wert der vorbestimmten Größe des Ausgangssignals (sₒᵤₜ) dividiert durch die erste Verstärkung (K1), wenn der Wert der vorbestimmten Größe des Ausgangssignals (sₒᵤₜ) nicht das gleiche Vorzeichen wie die erste Verstärkung (K1) hat;
- der Wert der vorbestimmten Größe des Ausgangssignals (sₒᵤₜ) dividiert durch die zweite Verstärkung (K2), wenn der Wert der vorbestimmten Größe des Ausgangssignals (sₒᵤₜ) das gleiche Vorzeichen wie die erste Verstärkung (K1) hat.

6. Messgerät (2), eine Verstärkervorrichtung (2) nach Anspruch 2 oder 3 umfassend und einen Rechner (6), der an die Ausgangsklemme (16) der Verstärkervorrichtung (2) angeschlossen ist,
wobei der Rechner (6) konfiguriert ist, um einen Wert einer vorbestimmten Eigenschaft eines Eingangssignals (sᵢₙ) mit vorbestimmtem Vorzeichen zu berechnen, das am Eingang des Messgerätes (2) angelegt ist, der gleich ist, wie:
- wenn das Eingangssignal (sᵢₙ) positiv ist:
- der Wert der vorbestimmten Größe des Ausgangssignals (sₒᵤₜ) dividiert durch die vorläufige Verstärkung (G) und durch die erste Verstärkung (K1), wenn der Wert der vorbestimmten Größe eines Ausgangssignals (sₒᵤₜ), das an der Ausgangsklemme (16) verfügbar ist, das gleiche Vorzeichen wie das Produkt der vorläufigen Verstärkung (G) und der ersten Verstärkung (K1) hat;
- der Wert der vorbestimmten Größe des Ausgangssignals (sₒᵤₜ) dividiert durch die vorläufige Verstärkung (G) und durch die zweite Verstärkung (K2), wenn der Wert der vorbestimmten Größe des Ausgangssignals (sₒᵤₜ) nicht das gleiche Vorzeichen wie das Produkt der vorläufigen Verstärkung (G) und der ersten Verstärkung (K1) hat;
- wenn das Eingangssignal (sᵢₙ) negativ ist:
- der Wert der vorbestimmten Größe des Ausgangssignals (sₒᵤₜ) dividiert durch die vorläufige Verstärkung (G) und durch die erste Verstärkung (K1), wenn der Wert der vorbestimmten Größe des Ausgangssignals (sₒᵤₜ) nicht das gleiche Vorzeichen wie das Produkt der vorläufigen Verstärkung (G) und der ersten Verstärkung (K1) hat;
- der Wert der vorbestimmten Größe des Ausgangssignals (sₒᵤₜ) dividiert durch die vorläufige Verstärkung (G) und durch die zweite Verstärkung (K2), wenn der Wert der vorbestimmten Größe des Ausgangssignals (sₒᵤₜ) das gleiche Vorzeichen wie das Produkt der vorläufigen Verstärkung (G) und der ersten Verstärkung (K1) hat.

7. Verfahren zur Messung des Wertes einer vorbestimmten Eigenschaft eines Eingangssignals (sᵢₙ) mit vorbestimmtem Vorzeichen, das am Eingang des Messgerätes (2) nach Anspruch 6 angelegt ist, wobei das Verfahren die Schritte beinhaltet:
- Messung des Wertes der vorbestimmten Größe des Ausgangssignals (sₒᵤₜ);
- Berechnung des Wertes der vorbestimmten Eigenschaft des Eingangssignals (sᵢₙ), wobei der Wert der vorbestimmten Eigenschaft des Eingangssignals (sᵢₙ) gleich ist, wie:
- wenn das Eingangssignal (sᵢₙ) positiv ist:
- der Wert der vorbestimmten Größe des Ausgangssignals (sₒᵤₜ) dividiert durch die vorläufige Verstärkung (G) und durch die erste Verstärkung (K1), wenn der Wert der vorbestimmten Größe des Ausgangssignals (sₒᵤₜ) das gleiche Vorzeichen wie das Produkt der vorläufigen Verstärkung (G) und der ersten Verstärkung (K1) hat;
- der Wert der vorbestimmten Größe des Ausgangssignals (sₒᵤₜ) dividiert durch die vorläufige Verstärkung (G) und durch die zweite Verstärkung (K2), wenn der Wert der vorbestimmten Größe des Ausgangssignals (sₒᵤₜ) nicht das gleiche Vorzeichen wie das Produkt der vorläufigen Verstärkung (G) und der ersten Verstärkung (K1) hat;
- wenn das Eingangssignal (sᵢₙ) negativ ist:
- der Wert der vorbestimmten Größe des Ausgangssignals (sₒᵤₜ) dividiert durch die vorläufige Verstärkung (G) und durch die erste Verstärkung (K1), wenn der Wert der vorbestimmten Größe des Ausgangssignals (sₒᵤₜ) nicht das gleiche Vorzeichen wie das Produkt der vorläufigen Verstärkung (G) und der ersten Verstärkung (K1) hat;
- der Wert der vorbestimmten Größe des Ausgangssignals (sₒᵤₜ) dividiert durch die vorläufige Verstärkung (G) und durch die zweite Verstärkung (K2), wenn der Wert der vorbestimmten Größe des Ausgangssignals (sₒᵤₜ) das gleiche Vorzeichen wie das Produkt der vorläufigen Verstärkung (G) und der ersten Verstärkung (K1) hat.

## Claims

1. An amplification device (2) including an intermediate terminal (12) for receiving an intermediate signal (sᵢₙₜ), an output terminal (16) and an amplification stage (14), the amplification stage (14) being connected between the intermediate terminal (12) and the output terminal (16),
the amplification device (2) being **characterised in that** the amplification stage (14) comprises:
- a switch (18) including an output (18S) connected to the output terminal (16), a first input (18E1) and a second input (18E2), the switch (18) being able to switch between a first position, in which the output (18S) is connected to the first input (18E1), and a second position, in which the output (18S) is connected to the second input (18E2);
- a first branch (20) connected between the intermediate terminal (12) and the first input (18E1) of the switch (18), the first branch (20) being configured to apply a first gain (K1) to the intermediate signal (sᵢₙₜ) in order to generate a first amplified signal (sₐ₁) for being delivered to the first input (18E1) of the switch (18);
- a second branch (22) connected between the intermediate terminal (12) and the second input (18E2) of the switch (18), the second branch (22) being configured to apply a second gain (K2) to the intermediate signal (sᵢₙₜ) in order to generate a second amplified signal (sₐ₂) for being delivered to the second input (18E2) of the switch (18);
- a controller (24) configured to control switching of the switch (18):
- in the first position to apply the first amplified signal (sₐ₁) to the output terminal (16), if the value of a predetermined quantity of the first amplified signal (sₐ₁) belongs to a predetermined range;
- in the second position to apply the second amplified signal (sₐ₂) to the output terminal (16), if the value of the predetermined quantity of the first amplified signal (sₐ₁) is outside the predetermined range;
**characterised in that** the first gain (K1) and the second gain (K2) are non-null real numbers having opposite signs.

2. The amplification device (2) according to claim 1, the amplification device (2) further including an input terminal (8) and a preamplifier (10) connected between the input terminal (8) and the intermediate terminal (12),
the preamplifier (10) being configured to apply a preliminary gain (G) to an input signal (sᵢₙ) received from the input terminal (8) to generate the intermediate signal (sᵢₙₜ) for being delivered to the intermediate terminal (12),
the preliminary gain (G) being a non-null real number.

3. The amplification device (2) according to claim 2, wherein the second branch (22) of the amplification stage (14) has a unity gain.

4. A measurement apparatus (2), comprising an amplification device (2) according to claim 1, and a calculator (6) connected to the output terminal (16) of the amplification device (2),
the calculator (6) being configured to calculate a value of a predetermined characteristic of an intermediate signal (sᵢₙₜ) having a predetermined sign received by the intermediate terminal (12) of the measurement apparatus (2) equal:
- if the intermediate signal (sᵢₙₜ) is positive, to:
- the value of the predetermined quantity of the output signal (sₒᵤₜ) available at the output terminal (16) divided by the first gain (K1), if the value of the predetermined quantity of the output signal (sₒᵤₜ) is of the same sign as the first gain (K1);
- the value of the predetermined quantity of the output signal (sₒᵤₜ) divided by the second gain (K2), if the value of the predetermined quantity of the output signal (sₒᵤₜ) is not of the same sign as the first gain (K1);
- if the intermediate signal (sᵢₙₜ) is negative, to:
- the value of the predetermined quantity of the output signal (sₒᵤₜ) divided by the first gain (K1), if the value of the predetermined quantity of the output signal (sₒᵤₜ) is not of the same sign as the first gain (K1);
- the value of the predetermined quantity of the output signal (sₒᵤₜ) divided by the second gain (K2), if the value of the predetermined quantity of the output signal (sₒᵤₜ) is of the same sign as the first gain (K1).

5. A method for measuring the value of a predetermined characteristic of an intermediate signal (sᵢₙₜ) having a predetermined sign and applied to the intermediate terminal (12) of the measurement apparatus (2) according to claim 4, the method including the steps of:
- measuring the value of the predetermined quantity of the output signal (sₒᵤₜ);
- calculating the value of the predetermined characteristic of the input signal (sᵢₙ), the value of the predetermined characteristic of the input signal (sᵢₙₜ) being equal:
- if the intermediate signal (sᵢₙₜ) is positive, to:
- the value of the predetermined quantity of the output signal (sₒᵤₜ) divided by the first gain (K1), if the value of the predetermined quantity of the output signal (sₒᵤₜ) is of the same sign as the first gain (K1);
- the value of the predetermined quantity of the output signal (sₒᵤₜ) divided by the second gain (K2), if the value of the predetermined quantity of the output signal (sₒᵤₜ) is not of the same sign as the first gain (K1);
- if the intermediate signal (sᵢₙₜ) is negative, to:
- the value of the predetermined quantity of the output signal (sₒᵤₜ) divided by the first gain (K1), if the value of the predetermined quantity of the output signal (sₒᵤₜ) is not of the same sign as the first gain (K1);
- the value of the predetermined quantity of the output signal (sₒᵤₜ) divided by the second gain (K2), if the value of the predetermined quantity of the output signal (sₒᵤₜ) is of the same sign as the first gain (K1).

6. A measurement apparatus (2), including an amplification device (2) according to claim 2 or 3, and a calculator (6) connected to the output terminal (16) of the amplification device (2),
the calculator (6) being configured to calculate a value of a predetermined characteristic of an input signal (sᵢₙ) having a predetermined sign, input to the measurement apparatus (2) equal:
- if the input signal (sᵢₙ) is positive, to:
- the value of the predetermined quantity of the output signal (sₒᵤₜ) divided by the preliminary gain (G) and by the first gain (K1), if the value of the predetermined quantity of the output signal (sₒᵤₜ) available at the output terminal (16) is of the same sign as the product of the preliminary gain (G) and the first gain (K1);
- the value of the predetermined quantity of the output signal (sₒᵤₜ) divided by the preliminary gain (G) and by the second gain (K2), if the value of the predetermined quantity of the output signal (sₒᵤₜ) is not of the same sign as the product of the preliminary gain (G) and the first gain (K1);
- if the input signal (sᵢₙ) is negative, to:
- the value of the predetermined quantity of the output signal (sₒᵤₜ) divided by the preliminary gain (G) and by the first gain (K1), if the value of the predetermined quantity of the output signal (sₒᵤₜ) is not of the same sign as the product of the preliminary gain (G) and the first gain (K1);
- the value of the predetermined quantity of the output signal (sₒᵤₜ) divided by the preliminary gain (G) and by the second gain (K2), if the value of the predetermined quantity of the output signal (sₒᵤₜ) is of the same sign as the product of the preliminary gain (G) and the first gain (K1).

7. A method for measuring the value of a predetermined characteristic of an input signal (sᵢₙ) having a predetermined sign input to the measurement apparatus (2) according to claim 6, the method including the steps of:
- measuring the value of the predetermined quantity of the output signal (sₒᵤₜ);
- calculating the value of the predetermined characteristic of the input signal (sᵢₙ), the value of the predetermined characteristic of the input signal (sᵢₙ) being equal:
- if the input signal (sᵢₙ) is positive, to:
- the value of the predetermined quantity of the output signal (sₒᵤₜ) divided by the preliminary gain (G) and by the first gain (K1), if the value of the predetermined quantity of the output signal (sₒᵤₜ) is of the same sign as the product of the preliminary gain (G) and the first gain (K1);
- the value of the predetermined quantity of the output signal (sₒᵤₜ) divided by the preliminary gain (G) and by the second gain (K2), if the value of the predetermined quantity of the output signal (sₒᵤₜ) is not of the same sign as the product of the preliminary gain (G) and the first gain (K1);
- if the input signal (sᵢₙ) is negative, to:
- the value of the predetermined quantity of the output signal (sₒᵤₜ) divided by the preliminary gain (G) and by the first gain (K1), if the value of the predetermined quantity of the output signal (sₒᵤₜ) is not of the same sign as the product of the preliminary gain (G) and the first gain (K1);
- the value of the predetermined quantity of the output signal (sₒᵤₜ) divided by the preliminary gain (G) and by the second gain (K2), if the value of the predetermined quantity of the output signal (sₒᵤₜ) is of the same sign as the product of the preliminary gain (G) and the first gain (K1).
